# DEMANDE DE BREVET EUROPEEN

(11) **EP 4 102 307 A1**
(43) Date de publication de la demande: **14.12.2022**
(21) Numéro de dépôt: 22164221.8
(22) Date de dépôt: 24.03.2022
(51) Int. Cl.: G04B 19/10, A44C 15/00, G04B 19/12, G04B 19/30, G04B 19/32, G04B 37/22, G04B 45/00, G04G 9/10, H01L 27/15

(54) **PIÈCE D'HORLOGERIE À ILLUMINATION LOCALISÉE**

(30) Priorité: 08.06.2021 EP 21178245
(71) Demandeur: The Swatch Group Research and Development Ltd, 2074 Marin (CH)
(72) Inventeur: WILLEMIN, Michel, 2515 Prêles (CH); CURCHOD, Loïc, 1004 Lausanne (CH); TORTORA, Pierpasquale, 2000 Neuchâtel (CH); SPRINGER, Simon, 3007 Berne (CH); FAURE, Cédric, 2016 Cortaillod (CH)
(74) Mandataire: ICB SA

(57) **Abrégé**

L'invention concerne une pièce d'horlogerie comportant, en plus d'une glace (34), les éléments d'habillage suivants : un fond (2), une carrure (1), un cadran (3) et deux brins (30) de bracelet, l'un au moins de ces éléments d'habillage comprenant au moins une partie constituée d'un matériau céramique au moins partiellement transparent ou translucide, la pièce d'horlogerie comportant en outre au moins deux sources de lumière ponctuelles (10) produisant un dégagement de chaleur, chaque source de lumière (10) étant susceptible d'être allumée/éteinte distinctement et étant disposée dans ou directement sous ledit au moins un élément d'habillage comprenant le matériau céramique, chaque source de lumière (10) produisant une lumière qui passe à travers le matériau céramique dudit élément d'habillage, et en ce que chaque source de lumière (10) est configurée pour produire une lumière localisée sur une zone ponctuelle ou quasi-ponctuelle (40) du matériau céramique de l'élément d'habillage concerné, de sorte à produire une illumination localisée sur ledit élément d'habillage.

## Description

### Domaine technique de l'invention

La présente invention concerne une pièce d'horlogerie à illumination localisée. Plus précisément, la présente invention concerne une pièce d'horlogerie présentant des jeux de lumière localisés originaux, dans un but fonctionnel, esthétique et/ou ludique. La présente invention concerne également une utilisation d'une telle pièce d'horlogerie pour obtenir de nouvelles applications fonctionnelles originales d'illuminations sur la pièce d'horlogerie.

### Arrière-plan technologique

Créer des pièces d'horlogerie telles que des montres-bracelets présentant un aspect esthétique amélioré est une préoccupation de tous les instants chez les fabricants horlogers et notamment chez les personnes chargées de concevoir les divers éléments d'habillage. Il serait trop long de dresser ici la liste de toutes les solutions qui ont été envisagées pour impartir à une pièce d'horlogerie un aspect aussi soigné et esthétique que possible. A titre d'exemple seulement, on peut citer la technique du guillochage des cadrans, la forme et/ou la couleur des appliques du cadran ou des aiguilles ou bien encore l'ajout de pierres précieuses ou semi-précieuses.

La présente invention s'inscrit dans la quête qui vise à proposer à la clientèle des montres dont l'aspect est tout à la fois esthétique, surprenant et fonctionnel.

Dans ce contexte, il est connu, par exemple du document brevet WO 2010/146162 A1, d'illuminer une pièce d'horlogerie dont au moins un élément d'habillage est au moins partiellement transparent ou translucide. La pièce d'horlogerie, typiquement une montre, comporte une ou plusieurs sources de lumière qui permettent d'éclairer l'élément d'habillage de la montre depuis l'intérieur du boîtier, sous le cadran, en produisant une lumière qui passe à travers la partie transparente ou translucide de cet élément d'habillage. Le pourtour latéral de la carrure de la montre, des zones autour de la couronne de remontoir et/ou des boutons-poussoirs, ou encore des éléments optiques vers les brins de bracelet peuvent ainsi être éclairés. Le cadran peut également être éclairé via des zones sélectivement semi-transparentes (appliques) prévues sur ce dernier.

Toutefois, un inconvénient de ce type de pièce d'horlogerie est qu'elle se limite à l'obtention d'un effet esthétique spécial global, permettant optionnellement la lecture de l'heure et de la date dans la nuit grâce à l'illumination directe ou indirecte de la position des aiguilles et de l'affichage de la date. Une telle pièce d'horlogerie ne permet pas en particulier d'indiquer des informations ponctuelles ou localisées en plusieurs points discrets de la pièce par affichage lumineux, de manière esthétique.

### Résumé de l'invention

L'invention pallie les inconvénients de l'art antérieur en procurant une pièce d'horlogerie à illumination localisée en plusieurs points de la pièce, simple à réaliser et présentant des jeux de lumière localisés originaux, dans un but fonctionnel, esthétique et/ou ludique.

A cet effet, la présente invention concerne une pièce d'horlogerie comportant, en plus d'une glace, les éléments d'habillage suivants : un fond, une carrure, un cadran et deux brins de bracelet, l'un au moins de ces éléments d'habillage comprenant au moins une partie constituée d'un matériau céramique au moins partiellement transparent ou translucide, la pièce d'horlogerie comportant en outre au moins deux sources de lumière ponctuelles produisant un dégagement de chaleur, chaque source de lumière étant susceptible d'être allumée/éteinte distinctement et étant disposée dans ou directement sous ledit au moins un élément d'habillage comprenant le matériau céramique, chaque source de lumière produisant une lumière qui passe à travers le matériau céramique dudit élément d'habillage. Selon l'invention, chaque source de lumière est configurée pour produire une lumière localisée sur une zone ponctuelle ou quasi-ponctuelle du matériau céramique de l'élément d'habillage concerné, de sorte à produire une illumination localisée sur ledit élément d'habillage.

L'utilisation d'un matériau céramique au moins partiellement transparent ou translucide, combinée au fait que chaque source de lumière est configurée pour produire une lumière localisée sur une zone ponctuelle ou quasi-ponctuelle de ce matériau céramique, permet d'obtenir une pièce d'horlogerie à illumination localisée, simple à fabriquer, et qui s'éclaire depuis l'intérieur de la pièce d'horlogerie en plusieurs points de cette dernière, à des fins fonctionnelles (notamment pour afficher des informations normalement cachées), esthétiques et/ou ludiques. En outre, l'illumination a un aspect plus ou moins diffus, discret, doux et agréable, ces caractéristiques pouvant être variées pratiquement à l'infini selon le rendu esthétique désiré, ce qui augmente la qualité esthétique finale de la pièce d'horlogerie. La pièce d'horlogerie selon l'invention peut être par exemple une montre électronique, électromécanique et/ou mécanique, et notamment une montre sportive ou une montre dite « de luxe ».

Selon les modèles de montre envisagés (notamment ceux intégrant des éléments d'habillage en céramique préexistants), la présente invention présente en outre l'avantage de pouvoir être implémentée en ne modifiant que des composants internes au boîtier de montre (centre-acier, fond, etc.), sans devoir introduire des structures complexes dans les éléments d'habillage en céramique. Ceci permet d'intégrer les caractéristiques d'illumination selon l'invention dans des références de montres existantes sans devoir modifier les moules d'injection.

Des formes particulières de la pièce d'horlogerie sont définies dans les revendications dépendantes 2 à 16.

Selon un premier mode de réalisation de l'invention, chaque source de lumière ponctuelle est une boîte ou point quantique (appelé respectivement « quantum box » ou « quantum dot » en anglais).

Selon un second mode de réalisation de l'invention, chaque source de lumière ponctuelle est une diode électroluminescente montée sur un support du type plaquette de circuit imprimé, de préférence sur une plaquette de circuit imprimé flexible. Chaque source de lumière ponctuelle est alimentée par exemple par une batterie interchangeable ou rechargeable ou bien encore par une cellule solaire.

Selon une première variante de réalisation, chaque diode électroluminescente est un composant monté en surface CMS ou encore SMD (de l'anglais « Surface Mounted Device), de préférence un composant monté en surface CMS et encapsulé et/ou soudé en surface.

Selon une seconde variante de réalisation, chaque diode électroluminescente est une puce à diode électroluminescente sur circuit imprimé, de préférence une puce à diode électroluminescente munie d'un matériau d'imprégnation transparent.

Avantageusement, la pièce d'horlogerie comporte en outre un circuit électronique de commande des diodes électroluminescentes, ledit circuit électronique de commande étant configuré pour piloter chaque diode électroluminescente indépendamment des autres diodes. Le circuit électronique de commande pilote la commutation des diodes électroluminescentes selon la fonction choisie, ou sur demande de l'utilisateur via une action sur un bouton ou sur la couronne du remontoir ou encore sur une zone tactile de la pièce d'horlogerie.

Selon une variante de réalisation de l'invention, chaque source de lumière ponctuelle est disposée sur une surface interne de l'élément d'habillage à éclairer. Ceci permet de rapprocher chaque source de lumière ponctuelle de la surface externe de l'élément d'habillage à éclairer, pour un meilleur rendu esthétique de l'éclairage.

Selon une autre variante de réalisation de l'invention, au moins deux logements intérieurs sont ménagés dans l'élément d'habillage à éclairer, chaque source de lumière ponctuelle étant disposée dans un desdits logements intérieurs. Ceci permet là encore de rapprocher chaque source de lumière ponctuelle de la surface externe de l'élément d'habillage à éclairer. Les logements intérieurs peuvent être prévus dans le moule d'injection de la pièce d'horlogerie ou usinés après frittage de cette dernière.

Avantageusement, l'épaisseur de l'élément d'habillage à éclairer est choisie de telle sorte que chaque source de lumière ponctuelle disposée dans ou directement sous ledit élément d'habillage est invisible lorsque la source de lumière est éteinte. Ceci permet d'améliorer encore la qualité esthétique et la discrétion de l'éclairage, et donc d'améliorer le rendu esthétique de la pièce d'horlogerie.

Avantageusement, l'élément d'habillage à éclairer est la carrure de la pièce d'horlogerie, et l'épaisseur de la carrure est comprise entre 1 mm et 5 mm, de préférence est inférieure à 2 mm. Une telle épaisseur procure une illumination particulièrement efficace sur la carrure.

Avantageusement, chaque source de lumière ponctuelle est montée sur une pièce mobile de la pièce d'horlogerie, sous l'élément d'habillage à éclairer, par exemple montée sur une pseudo-aiguille configurée pour tourner autour de l'axe des aiguilles. Ceci permet d'obtenir un rendu d'éclairage dynamique et particulièrement esthétique, en particulier lorsque l'élément d'habillage à éclairer est la carrure ou la lunette de la montre.

Selon une caractéristique technique particulière de l'invention, les sources de lumière ponctuelles sont configurées de telle sorte que chaque zone ponctuelle ou quasi-ponctuelle éclairable du matériau céramique est apte à être éclairée par une seule source de lumière ponctuelle monochrome.

Selon une autre caractéristique technique particulière de l'invention, les sources de lumière ponctuelles sont configurées de telle sorte que chaque zone ponctuelle ou quasi-ponctuelle éclairable du matériau céramique est apte à être éclairée par plusieurs sources de lumière ponctuelles présentant des couleurs lumineuses distinctes. Ceci permet d'obtenir une émission de plusieurs couleurs en chaque point ou quasi-point illuminé de l'élément d'habillage.

Un autre aspect de l'invention concerne une utilisation d'une pièce d'horlogerie telle que décrite ci-dessus, dans laquelle l'allumage et l'extinction des sources de lumière ponctuelles produisant un dégagement de chaleur sont configurés de manière telle que la pièce d'horlogerie présente, sur l'élément d'habillage éclairé par les sources de lumière ponctuelles, au moins une indication visuelle d'une fonction propre à la pièce d'horlogerie et/ou relative à une mesure d'un paramètre extérieur ou d'un paramètre concernant l'utilisateur de la pièce d'horlogerie.

Selon une caractéristique technique particulière de l'invention, l'allumage et l'extinction des sources de lumière ponctuelles sont configurés de manière telle que la pièce d'horlogerie présente, sur l'élément d'habillage éclairé par les sources de lumière ponctuelles, une ou plusieurs indications visuelles relatives à une ou plusieurs des fonctionnalités suivantes : indication de l'heure, des minutes et/ou de la date ; indication d'un chronomètre ou d'un compte à rebours avec des zones lumineuses ponctuelles ou quasi-ponctuelles de l'élément d'habillage qui s'allument, respectivement s'éteignent, au fur et à mesure du temps écoulé ; indication d'une grandeur mesurée par la pièce d'horlogerie par illumination modulée en couleur, en rythme, en fréquence et/ou en intensité sur l'élément d'habillage, par exemple indication d'un rythme cardiaque, d'une température, d'un rythme de course, d'un nombre de pas ou encore d'un niveau de décibels ; indication d'une alarme ou d'une réception de notification ; indication d'une fonction active pour la pièce d'horlogerie ; aide au réglage de la pièce d'horlogerie.

Selon une autre caractéristique technique particulière de l'invention, l'allumage et/ou l'extinction des sources de lumière ponctuelles est commandé(e) de manière simultanée et/ou en séquence.

### Brève description des figures

Les buts, avantages et caractéristiques de la pièce d'horlogerie selon l'invention apparaîtront mieux dans la description suivante sur la base d'au moins une forme d'exécution non limitative illustrée par les dessins sur lesquels :
- la figure 1 est une vue en coupe d'une boîte de montre selon un mode de réalisation de l'invention, la boîte de montre étant équipée de deux sources de lumière ponctuelles ;
- la figure 2 est une vue de dessus d'une montre-bracelet comprenant une lunette sur laquelle une illumination ponctuelle indique l'heure ;
- la figure 3 est une vue analogue à celle de la figure 2, dans laquelle deux illuminations ponctuelles sur la lunette indiquent l'heure et les minutes ; et
- la figure 4 est une vue analogue à celle de la figure 2, dans laquelle plusieurs illuminations ponctuelles sur la lunette indiquent un compte à rebours ou un chronomètre lumineux.

### Description détaillée de l'invention

La présente invention procède de l'idée générale inventive qui consiste à loger au moins deux sources de lumière ponctuelles dans ou sous au moins un élément d'habillage d'une pièce d'horlogerie comprenant un matériau céramique transparent ou translucide, la lumière, encore appelée rayonnement lumineux ou radiation lumineuse, produite par chaque source de lumière ponctuelle étant localisée sur une zone ponctuelle ou quasi-ponctuelle du matériau céramique de l'élément d'habillage concerné, de sorte à produire une illumination localisée sur ledit élément d'habillage. On notera que chaque source de lumière ponctuelle est apte à produire un dégagement de chaleur notamment par effet joule. On procure ainsi une pièce d'horlogerie à illumination localisée en plusieurs points de la pièce, simple à réaliser et présentant des jeux de lumière localisés originaux, dans un but fonctionnel, esthétique et/ou ludique. De plus, la source de lumière est dite ponctuelle en opposition à une source de lumière étendue. Cette source ponctuelle est configurée pour émettre une lumière qui apparait concentrée en un point minuscule.

Lorsque l'illumination est enclenchée, les zones de lumière localisées sur l'élément d'habillage transmettent une lumière plus ou moins forte et diffuse selon la construction et la puissance lumineuse installée, créant ainsi des effets fonctionnels, esthétiques et/ou ludiques surprenants, par contraste avec les parties non éclairées de l'élément d'habillage.

Dans la pièce d'horlogerie, l'élément d'habillage est de préférence une pièce monobloc. Dans une variante, l'élément d'habillage est de préférence une pièce monobloc en céramique.

On entend par « zone ponctuelle ou quasi-ponctuelle » toute zone localisée sur le matériau céramique de l'élément d'habillage concerné, et présentant des dimensions telles qu'elle est perçue comme distincte des zones voisines par un œil humain.

Dans la description suivante, toutes les parties de la pièce d'horlogerie qui sont bien connues de l'homme du métier ne seront expliquées que de manière simplifiée.

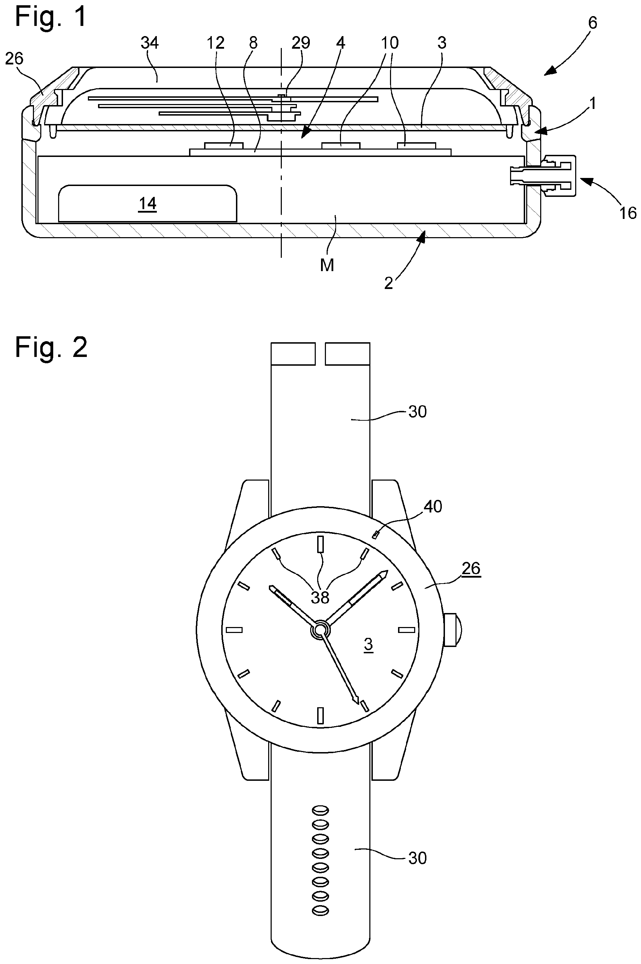

La figure 1 est une vue en coupe d'une carrure 1 délimitant avec un fond 2 et un cadran 3 un volume intérieur 4 d'une boîte de montre 6. La boîte de montre 6 est fermée sur le dessus par une glace 34. Pour les besoins de la présente description, on imaginera que la montre est une montre électronique et que son mouvement M est disposé dans le fond de la boîte de montre 6. De la sorte, on peut disposer au-dessus du mouvement M une plaque-support 8 du type plaquette de circuit imprimé ou PCB sur laquelle sont montées deux sources de lumière ponctuelles 10, par exemple du type diodes électroluminescentes ou LED, et leur circuit électronique de commande 12. La lumière sortant de chaque source de lumière ponctuelle 10 éclaire une zone ponctuelle ou quasi-ponctuelle de l'élément d'habillage à éclairer, à savoir le cadran 3 dans le mode de réalisation particulier de la figure 1. Pour ce faire, la lumière issue de chaque source de lumière ponctuelle 10 peut par exemple être collimatée ou focalisée vers la zone ponctuelle ou quasi-ponctuelle en question, dans ce cas cette source de lumière comprend un élément de collimation ou focalisation. Chaque source de lumière peut aussi comprendre un élément conducteur de ses radiations.

Dans le mode de réalisation particulier de la figure 1, chaque source de lumière ponctuelle 10 est disposée directement sous l'élément d'habillage par exemple le cadran 3 à éclairer. La source de lumière est alors positionnée par plaquage, collage ou par tous autres types de moyens sur une surface interne de cet élément d'habillage où doit être localisée la zone ponctuelle ou quasi-ponctuelle. On peut également prévoir, selon une variante non représentée, que chaque source de lumière ponctuelle 10 soit montée sur une pièce mobile de la pièce d'horlogerie, directement sous l'élément d'habillage à éclairer. Par exemple, lorsque l'élément d'habillage à éclairer est une lunette 26 montée sur la carrure 1, chaque source de lumière ponctuelle 10 peut être montée sur une pseudo-aiguille configurée pour tourner autour de l'axe des aiguilles 29. On notera qu'il convient d'entendre par « directement sous ledit élément d'habillage » que chaque source de lumière est disposée :
- à proximité immédiate de la surface interne de cet élément d'habillage où est localisée la zone ponctuelle ou quasi-ponctuelle et ce, sans élément intermédiaire disposé dans l'espace défini entre cette source de lumière et cette surface interne dans cette configuration;
- en contact avec la surface interne de cet élément d'habillage où est localisée la zone ponctuelle ou quasi-ponctuelle ;

Selon une variante, chaque source de lumière ponctuelle 10 est disposée en tout ou partie dans l'élément d'habillage à éclairer. Dans ce cas précis, au moins deux logements intérieurs sont ménagés dans l'élément d'habillage à éclairer, chaque source de lumière ponctuelle 10 étant disposée dans un des logements intérieurs. Ces logements intérieurs sont des cavités ou encore des trous borgnes. Dans cette configuration l'ouverture de chaque logement ou (trou borgne) est comprise dans la surface interne de l'élément d'habillage. Ces logements intérieurs peuvent être prévus dans le moule d'injection de l'élément d'habillage ou usinés après frittage de ce dernier. On notera que ces logements sont localisés dans la zone ponctuelle ou quasi-ponctuelle.

Tout type de source de lumière ponctuelle 10 produisant un dégagement de chaleur par effet joule, tel que diode électroluminescente ou autre, peut être utilisé. Dans un mode particulier de réalisation de l'invention, on utilise des diodes électroluminescentes émettant chacune de la lumière ultraviolette, violette, bleue, blanche ou infrarouge en combinaison avec un élément d'habillage comprenant un matériau céramique au moins partiellement transparent ou translucide, chargé de particules fluorescentes et/ou phosphorescentes. L'élément d'habillage est chargé à l'endroit ou aux endroits où l'on souhaite que la lumière s'échappe depuis l'intérieur de la boîte de montre 6. De la sorte, les particules fluorescentes et/ou phosphorescentes absorbent le rayonnement émis par chaque diode et réémettent une lumière visible homogène. En fonction du type de particules choisi, fluorescentes et/ou phosphorescentes, l'effet lumineux cesse aussitôt après extinction de la source lumineuse ou au contraire se poursuit par effet de rémanence. En variante non représentée sur les figures, les sources de lumière ponctuelles 10 peuvent être des boîtes ou points quantiques (appelés respectivement « quantum box » ou « quantum dot » en anglais).

Dans un mode particulier de réalisation de l'invention, chaque source de lumière ponctuelle 10 est une source de lumière monochrome, et chaque zone ponctuelle ou quasi-ponctuelle éclairable sur le matériau céramique de l'élément d'habillage est éclairée par une seule source de lumière ponctuelle monochrome 10. Dans un autre mode de réalisation de l'invention, les sources de lumière ponctuelles 10 sont configurées pour présenter des couleurs lumineuses distinctes, et chaque zone ponctuelle ou quasi-ponctuelle éclairable sur le matériau céramique de l'élément d'habillage est éclairée par plusieurs de ces sources de lumière ponctuelles 10.

De préférence, la plaquette de circuit imprimé ou PCB 8 est une plaquette flexible. Lorsque les sources de lumière ponctuelles 10 sont des diodes électroluminescentes, ces dernières peuvent être par exemple des composants montés en surface CMS ou encore SMD (de l'anglais « Surface Mounted Device), typiquement encapsulés et/ou soudés en surface ; ou encore des puces à diode électroluminescente sur circuit imprimé, typiquement munies d'un matériau d'imprégnation transparent. Le circuit de commande 12 est configuré pour piloter les diodes électroluminescentes selon la fonction choisie pour la pièce d'horlogerie, ou sur demande de l'utilisateur via une action de ce dernier sur un bouton-poussoir ou sur une couronne de remontoir ou encore sur une zone tactile de la pièce d'horlogerie. De préférence, le circuit électronique de commande 12 est configuré pour piloter chaque diode électroluminescente indépendamment des autres diodes. Autrement dit, l'allumage et l'extinction de chaque source de lumière ponctuelles 10 est contrôlé de manière distincte par ce circuit électronique de commande 12.

Chaque source de lumière ponctuelle 10 est alimentée par exemple par une batterie 14 rechargeable ou interchangeable et classiquement disposée sous le mouvement d'horlogerie M du côté du fond 2 de la boîte de montre 6. On comprendra que la montre selon l'invention peut être électronique, électromécanique voire purement mécanique. Dans ce dernier cas, il suffira de prévoir un logement pour recevoir une pile qui sera destinée à alimenter uniquement les sources de lumière 10 et leur circuit électronique de commande 12. Ainsi, la présente invention peut être appliquée à tout type de montre-bracelet, la seule contrainte à respecter étant qu'il n'y ait pas d'obstacle à la propagation de la lumière entre les sources de lumière ponctuelles et l'élément d'habillage par lequel ladite lumière doit sortir.

Dans le mode de réalisation particulier illustré sur la figure 1, l'élément d'habillage par lequel ladite lumière doit sortir est le cadran 3, qui est constitué d'un matériau céramique au moins partiellement transparent ou translucide. La présente invention est cependant applicable à tout autre élément d'habillage d'une pièce d'horlogerie comprenant une partie constituée d'un matériau céramique au moins partiellement transparent ou translucide, tel que par exemple la carrure 1, le fond 2, la lunette 26, un rehaut (non représenté sur les figures), ou encore des brins 30 de bracelet (visibles sur les figures 2 à 4). Selon un exemple de réalisation particulier, la partie d'élément d'habillage en matériau céramique, destinée à être éclairée, est une partie supérieure de la carrure 1 ou de la lunette 26.

Selon un mode de réalisation de l'invention non représenté sur les figures, on illumine une zone ponctuelle ou quasi-ponctuelle d'un organe de commande de la montre tel qu'un bouton-poussoir 16, plus précisément d'une partie de cet organe de commande constituée d'un matériau céramique au moins partiellement transparent ou translucide. Selon un autre mode de réalisation de l'invention, non représenté également sur les figures, on illumine au moins une zone ponctuelle ou quasi-ponctuelle d'une couronne de remontoir, éventuellement munie d'une coiffe de couronne. Dans ce cas, la couronne de remontoir et/ou la coiffe de couronne comprend au moins une partie constituée d'un matériau céramique au moins partiellement transparent ou translucide. L'illumination localisée est effectuée sur au moins une zone ponctuelle ou quasi-ponctuelle de cette partie de couronne de remontoir et/ou de coiffe de couronne.

On peut également prévoir, en variante non représentée, que l'élément d'habillage à éclairer comporte un insert en matériau céramique au moins partiellement transparent ou translucide. L'insert est prévu à l'endroit ou aux endroits où l'on souhaite que la lumière s'échappe depuis l'intérieur de la boîte de montre 6. Le reste de l'élément d'habillage est alors par exemple constitué d'un matériau distinct de la céramique, typiquement un matériau opaque. On peut également prévoir des éléments d'habillage mélangeant plusieurs couleurs de céramique à l'injection, notamment via des procédés de bi-injection, au moins une de ces multiples couleurs étant partiellement transparente ou translucide afin de laisser passer la lumière à des endroits prédéterminés et réalisés par le procédé de bi-injection.

Selon un mode de réalisation particulièrement avantageux de l'invention, l'épaisseur de l'élément d'habillage à éclairer est choisie de telle sorte que chaque source de lumière ponctuelle 10 disposée dans ou sous l'élément d'habillage est invisible lorsque la source de lumière 10 est éteinte. Ceci permet d'améliorer grandement le rendu esthétique de la pièce d'horlogerie. La puissance d'émission des sources de lumière ponctuelles 10 peut également être adaptée et combinée au choix d'épaisseur pour l'élément d'habillage, de manière à obtenir une telle invisibilité des sources de lumière 10 lorsqu'elles sont éteintes. Ceci permet en outre de rendre l'illumination plus ou moins diffuse ou directe, et douce ou forte, selon le rendu esthétique désiré. Lorsque l'élément d'habillage à éclairer est la carrure 1 de la pièce d'horlogerie, l'épaisseur de la carrure 1 est avantageusement choisie de manière à être comprise entre 1 mm et 5 mm. De préférence, afin d'obtenir une illumination particulièrement efficace, l'épaisseur de la carrure 1 est inférieure à 2 mm.

Selon un autre mode de réalisation de l'invention, les sources de lumière ponctuelles 10 peuvent être combinées avec une ou plusieurs inscription(s) écrite(s) dans le matériau céramique de l'élément d'habillage à éclairer :
- soit par variation d'épaisseur de la céramique par gravure mécanique ou laser (par exemple un retrait de quelques 0.1 mm dans la céramique),
- soit par variation de densité de la céramique,
- soit par une impression opaque ou semi-transparente à l'intérieur ou à la surface de l'élément d'habillage en céramique,
- ou encore par un dépôt physique en phase vapeur PVD (de l'anglais Physical Vapor Déposition) ou autre, structuré à l'intérieur ou à la surface de l'élément d'habillage,
- ou par une combinaison de ces méthodes.

Lorsque l'émission lumineuse des sources de lumière ponctuelles 10 est enclenchée, l'inscription normalement invisible apparaît en négatif à la surface du matériau céramique.

La pièce d'horlogerie selon la présente invention peut avantageusement être utilisée pour fournir des applications fonctionnelles diverses à un utilisateur de la pièce d'horlogerie. A cet effet, l'allumage et l'extinction de chaque sources de lumière ponctuelles 10 est contrôlé de manière distincte par le circuit électronique de commande 12. Autrement dit, chaque source de lumière peut être allumée ou éteinte distinctement. A cet effet, l'allumage et l'extinction des sources de lumière ponctuelles 10 sont configurés de manière à ce que la pièce d'horlogerie présente, sur l'élément d'habillage éclairé par les sources de lumière ponctuelles 10, au moins une indication visuelle d'une fonction propre à la pièce d'horlogerie et/ou relative à une mesure d'un paramètre extérieur ou d'un paramètre concernant l'utilisateur de la pièce d'horlogerie. L'allumage et/ou l'extinction des sources de lumière ponctuelles 10 peut être commandé(e) par le circuit électronique de commande 12 de manière simultanée et/ou en séquence.

Parmi les applications fonctionnelles possibles pour la pièce d'horlogerie, on peut par exemple citer :
- indication d'une grandeur mesurée par la pièce d'horlogerie par illumination modulée en couleur, en rythme, en fréquence, et/ou en intensité sur l'élément d'habillage. Par exemple :
   - indication du rythme cardiaque de l'utilisateur par une illumination pulsée à la même fréquence. On peut aussi varier la couleur de l'illumination en fonction de la fréquence, typiquement verte pour un rythme bas, puis de plus en plus rouge plus la fréquence cardiaque s'élève ;
   - indication de la température ambiante par illumination des chiffres ou appliques 38 sur le cadran 3 en séquences ou de leurs positions correspondantes 40 sur le tour de la carrure 1 et/ou de la lunette 26 (voir figure 2), en adaptant la couleur à la température (typiquement bleue pour des températures basses, et de plus en plus rouge pour des températures de plus en plus élevées) ;
   - indication (absolue ou relative) du rythme de course pour une montre sportive ;
   - indication du nombre de pas ou de toute autre mesure de l'activité sportive de l'utilisateur ;
   - indication d'un niveau de décibels (par exemple sur un chantier, en discothèque, etc.) ;
- indication de tout type d'alarme et utilisation de différentes combinaisons de rythmes / intensités / couleurs pour les différentes alarmes. Dans ce cas, de nombreux éléments d'habillage de la pièce d'horlogerie peuvent s'illuminer simultanément ou en séquence, y compris le bracelet. Exemples d'alarmes :
   - réveil matin ;
   - réception d'un message ou d'un courrier électronique (ou accusé de réception d'un message envoyé) ou toute autre notification de toute autre application pour une montre connectée à un dispositif mobile de type téléphone mobile ;
   - accusé de réception pour un paiement pour une montre disposant d'une fonctionnalité de paiement sans contact ;
- indication de la fonction active pour une montre multitâches, notamment la fonction « Heure », « Chrono », « Baro » (pour le baromètre »), « Podo » (pour le podomètre), etc. :
   - par illumination d'un chiffre ou applique 38 sur le cadran 3 correspondant à la fonction (1 = Chrono, 2 = Baromètre, etc...) ;
   - par illumination en transmission d'une ou plusieurs inscription(s) (par exemple des petits textes ou logos) imprimée(s) ou gravée(s) à l'intérieur de la montre (typiquement dans la carrure 1 et/ou la lunette 26), juste sous la surface, et qui sont invisibles en absence d'illumination ;
- aide au réglage de la montre, notamment pour les montres tactiles dont le réglage se fait sans bouton / couronne, ce qui peut rendre les opérations moins intuitives :
   - indication du niveau de réglage (ou menu) actif lors du réglage de la montre par illumination des chiffres ou appliques 38 sur le cadran 3 et/ou de petits textes et/ou logos cachés ;
   - éclairage de la couronne en matériau céramique lorsqu'elle est tirée pour effectuer le réglage de la montre ;
   - guide lumineux indiquant quel(s) bouton(s) et/ou partie(s) de la montre l'utilisateur peut/doit toucher lors de la prochaine étape de réglage. Les boutons eux-mêmes et/ou une zone autour des boutons peuvent être illuminés ;
   - confirmation lumineuse (par exemple via deux ou trois impulsions de lumière) pour indiquer à l'utilisateur que son réglage a bien été accepté par la montre.

Une autre application fonctionnelle possible pour la pièce d'horlogerie selon l'invention est illustrée sur la figure 2, où la pièce d'horlogerie est une montre-bracelet. Sur une zone ponctuelle ou quasi-ponctuelle 40 de la lunette 26 de la montre, une illumination localisée indique l'heure, à savoir 13 heures dans l'exemple illustré. La zone ponctuelle ou quasi-ponctuelle 40 correspond en effet à la position d'un chiffre ou applique 38 sur le cadran 3 de la montre. L'illumination localisée permet notamment la lecture de l'heure dans la nuit.

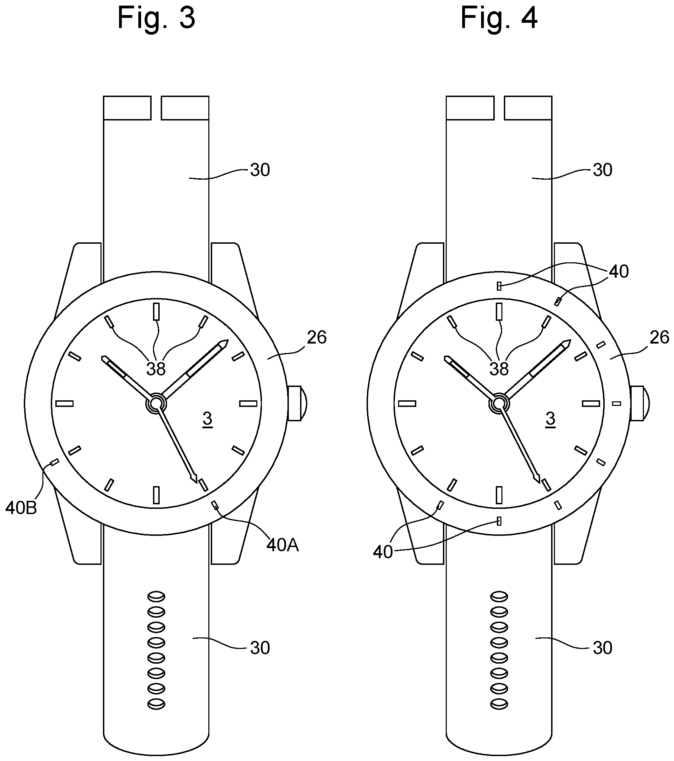

Une autre application fonctionnelle possible pour la pièce d'horlogerie selon l'invention est illustrée sur la figure 3, où la pièce d'horlogerie est une montre-bracelet. Sur une première zone ponctuelle ou quasi-ponctuelle 40A de la lunette 26 de la montre, une première illumination localisée indique l'heure, à savoir 5 heures dans l'exemple illustré. Sur une seconde zone ponctuelle ou quasi-ponctuelle 40B de la lunette 26 de la montre, une seconde illumination localisée indique les minutes, à savoir 40 minutes dans l'exemple illustré. La seconde illumination (correspondant aux minutes) peut se faire simultanément avec la première illumination (correspondant à l'heure). Les couleurs de lumière sur les première et seconde zones ponctuelles ou quasi-ponctuelles 40A, 40B peuvent être identiques (en cas d'illuminations en séquence) ou différentes (en cas d'illuminations simultanées). Ce dernier cas de figure permet en effet à l'utilisateur de la montre de pouvoir distinguer l'heure des minutes. Les première et seconde illuminations localisées permettent notamment la lecture de l'heure et des minutes dans la nuit.

Une autre application fonctionnelle possible pour la pièce d'horlogerie selon l'invention est illustrée sur la figure 4, où la pièce d'horlogerie est une montre-bracelet. Sur une ou plusieurs zones ponctuelles ou quasi-ponctuelles 40 de la lunette 26 de la montre, en l'occurrence sur huit zones 40 dans l'exemple illustré, plusieurs illuminations localisées indiquent un compte à rebours ou un chronomètre lumineux. Les zones ponctuelles ou quasi-ponctuelles 40 sur la lunette 26 peuvent s'allumer, respectivement s'éteindre, au fur et à mesure du temps écoulé.

Dans chacun des exemples de réalisation illustrés sur les figures 2 à 4, la pièce d'horlogerie comporte typiquement douze diodes électroluminescentes 10 montées en série sur une plaquette de circuit imprimé flexible 8. Chaque diode électroluminescente 10 est montée dans ou sous la lunette 26 et permet d'éclairer une zone ponctuelle ou quasi-ponctuelle 40 sur la lunette 26.

De manière alternative aux exemples de réalisation illustrés sur les figures 2 à 4, les zones ponctuelles ou quasi-ponctuelles 40 d'illumination localisée peuvent être prévues sur le pourtour de la carrure 1 de la montre, plutôt que sur la lunette 26.

Une autre application fonctionnelle possible pour la pièce d'horlogerie selon l'invention, similaire à celle de la figure 2 mais non représentée sur les figures, consiste afficher la date via une illumination localisée sur une zone ponctuelle ou quasi-ponctuelle 40 de la lunette 26 de la pièce d'horlogerie. La zone ponctuelle ou quasi-ponctuelle 40 correspond en effet à la position d'un chiffre ou applique 38 sur le cadran 3 de la montre. Pour les dates au-delà de « 12 », les deux chiffres du jour peuvent être indiqués en séquence, suivis du mois (par exemple « 2 » puis « 3 », puis « 1 » pour le 23 janvier). Une couleur lumineuse différente peut être utilisée pour le jour et le mois. L'illumination localisée permet notamment la lecture de la date dans la nuit.

Bien entendu, la liste ci-dessus des applications fonctionnelles rendues possibles par la pièce d'horlogerie selon l'invention n'est pas exhaustive et l'homme du métier pourra identifier d'autres applications fonctionnelles.

## Revendications

1. Pièce d'horlogerie comportant, en plus d'une glace (34), les éléments d'habillage suivants : un fond (2), une carrure (1), un cadran (3) et deux brins (30) de bracelet, l'un au moins de ces éléments d'habillage comprenant au moins une partie constituée d'un matériau céramique au moins partiellement transparent ou translucide, la pièce d'horlogerie comportant en outre au moins deux sources de lumière ponctuelles (10) produisant un dégagement de chaleur, chaque source de lumière (10) étant susceptible d'être allumée/éteinte distinctement et étant disposée dans ou directement sous ledit au moins un élément d'habillage comprenant le matériau céramique, chaque source de lumière (10) produisant une lumière qui passe à travers le matériau céramique dudit élément d'habillage, et en ce que chaque source de lumière (10) est configurée pour produire une lumière localisée sur une zone ponctuelle ou quasi-ponctuelle (40) du matériau céramique de l'élément d'habillage concerné, de sorte à produire une illumination localisée sur ledit élément d'habillage.

2. Pièce d'horlogerie selon la revendication 1, **caractérisée en ce que** chaque source de lumière ponctuelle (10) est une boîte ou point quantique.

3. Pièce d'horlogerie selon la revendication 1 ou 2, **caractérisée en ce que** chaque source de lumière ponctuelle (10) est une diode électroluminescente montée sur un support du type plaquette de circuit imprimé (8), de préférence sur une plaquette de circuit imprimé flexible.

4. Pièce d'horlogerie selon la revendication 3, **caractérisée en ce que** chaque diode électroluminescente (10) est un composant monté en surface CMS, de préférence un composant monté en surface CMS et encapsulé et/ou soudé en surface.

5. Pièce d'horlogerie selon la revendication 3, **caractérisée en ce que** chaque diode électroluminescente (10) est une puce à diode électroluminescente sur circuit imprimé, de préférence une puce à diode électroluminescente munie d'un matériau d'imprégnation transparent.

6. Pièce d'horlogerie selon l'une quelconque des revendications 3 à 5, **caractérisée en ce qu'**elle comporte en outre un circuit électronique (12) de commande des diodes électroluminescentes (10), ledit circuit électronique de commande (12) étant configuré pour piloter chaque diode électroluminescente (10) indépendamment des autres diodes.

7. Pièce d'horlogerie selon l'une quelconque des revendications précédentes, **caractérisée en ce que** chaque source de lumière ponctuelle (10) est disposée sur une surface interne de l'élément d'habillage à éclairer.

8. Pièce d'horlogerie selon l'une quelconque des revendications 1 à 6, **caractérisée en ce qu'**au moins deux logements intérieurs sont ménagés dans l'élément d'habillage à éclairer, chaque source de lumière ponctuelle (10) étant disposée dans un desdits logements intérieurs.

9. Pièce d'horlogerie selon l'une quelconque des revendications précédentes, **caractérisée en ce que** l'épaisseur de l'élément d'habillage à éclairer est choisie de telle sorte que chaque source de lumière ponctuelle (10) disposée dans ou directement sous ledit élément d'habillage est invisible lorsque la source de lumière (10) est éteinte.

10. Pièce d'horlogerie selon l'une quelconque des revendications précédentes, **caractérisée en ce que** l'élément d'habillage à éclairer est la carrure (1) de la pièce d'horlogerie, et **en ce que** l'épaisseur de la carrure (1) est comprise entre 1 mm et 5 mm, de préférence est inférieure à 2 mm.

11. Pièce d'horlogerie selon l'une quelconque des revendications précédentes, **caractérisée en ce que** chaque source de lumière ponctuelle (10) est montée sur une pièce mobile de la pièce d'horlogerie, sous l'élément d'habillage à éclairer, par exemple montée sur une pseudo-aiguille configurée pour tourner autour de l'axe des aiguilles (29).

12. Pièce d'horlogerie selon l'une quelconque des revendications précédentes, comprenant en outre une lunette (26) et/ou un bouton-poussoir (16) et/ou une couronne de remontoir munie d'une coiffe de couronne, **caractérisée en ce que** la lunette (26) et/ou la couronne de remontoir et/ou la coiffe de couronne et/ou le bouton-poussoir (16) est un élément d'habillage comprenant au moins une partie constituée d'un matériau céramique au moins partiellement transparent ou translucide.

13. Pièce d'horlogerie selon l'une quelconque des revendications précédentes, **caractérisée en ce que** l'élément d'habillage à éclairer comporte un insert en matériau céramique au moins partiellement transparent ou translucide, ledit insert étant prévu à l'endroit ou aux endroits où l'on souhaite que la lumière s'échappe depuis l'intérieur de la pièce d'horlogerie, le reste de l'élément d'habillage étant constitué d'un matériau distinct de la céramique, de préférence constitué d'un matériau opaque.

14. Pièce d'horlogerie selon l'une quelconque des revendications précédentes, **caractérisée en ce que** chaque source de lumière ponctuelle (10) est configurée pour émettre de la lumière ultraviolette, violette, bleue, blanche ou infrarouge et **en ce que** l'élément d'habillage à éclairer est chargé avec des particules phosphorescentes et/ou fluorescentes à l'endroit ou aux endroits où l'on souhaite que la lumière s'échappe depuis l'intérieur de la pièce d'horlogerie.

15. Pièce d'horlogerie selon l'une quelconque des revendications précédentes, **caractérisée en ce que** les sources de lumière ponctuelles (10) sont configurées de telle sorte que chaque zone ponctuelle ou quasi-ponctuelle éclairable (40) du matériau céramique est apte à être éclairée par une seule source de lumière ponctuelle monochrome (10).

16. Pièce d'horlogerie selon l'une quelconque des revendications 1 à 14, **caractérisée en ce que** les sources de lumière ponctuelles (10) sont configurées de telle sorte que chaque zone ponctuelle ou quasi-ponctuelle éclairable (40) du matériau céramique est apte à être éclairée par plusieurs sources de lumière ponctuelles (10) présentant des couleurs lumineuses distinctes.

17. Utilisation d'une pièce d'horlogerie selon l'une quelconque des revendications précédentes, lors de laquelle l'allumage et l'extinction des sources de lumière ponctuelles (10) produisant un dégagement de chaleur sont configurés de manière telle que la pièce d'horlogerie présente, sur l'élément d'habillage éclairé par les sources de lumière ponctuelles (10), au moins une indication visuelle d'une fonction propre à la pièce d'horlogerie et/ou relative à une mesure d'un paramètre extérieur ou d'un paramètre concernant l'utilisateur de la pièce d'horlogerie.

18. Utilisation d'une pièce d'horlogerie selon la revendication 17, **caractérisée en ce que** l'allumage et l'extinction des sources de lumière ponctuelles (10) sont configurés de manière telle que la pièce d'horlogerie présente, sur l'élément d'habillage éclairé par les sources de lumière ponctuelles (10), une ou plusieurs indications visuelles relatives à une ou plusieurs des fonctionnalités suivantes : indication de l'heure, des minutes et/ou de la date ; indication d'un chronomètre ou d'un compte à rebours avec des zones lumineuses ponctuelles ou quasi-ponctuelles (40) de l'élément d'habillage qui s'allument, respectivement s'éteignent, au fur et à mesure du temps écoulé ; indication d'une grandeur mesurée par la pièce d'horlogerie par illumination modulée en couleur, en rythme, en fréquence et/ou en intensité sur l'élément d'habillage, par exemple indication d'un rythme cardiaque, d'une température, d'un rythme de course, d'un nombre de pas ou encore d'un niveau de décibels ; indication d'une alarme ou d'une réception de notification ; indication d'une fonction active pour la pièce d'horlogerie ; aide au réglage de la pièce d'horlogerie.

19. Utilisation d'une pièce d'horlogerie selon la revendication 17 ou 18, **caractérisée en ce que** l'allumage et/ou l'extinction des sources de lumière ponctuelles (10) est commandé(e) de manière simultanée et/ou en séquence.
